# EUROPEAN PATENT APPLICATION

(11) **EP 1 843 205 A1**
(43) Date of publication of application: **10.10.2007**
(21) Application number: 07251277.5
(22) Date of filing: 26.03.2007
(51) Int. Cl.: G03F 7/20, G03F 9/00

(54) **Local treatment device, lithographic apparatus and device manufacturing method**

(30) Priority: 05.04.2006 US 397935
(71) Applicant: ASML Netherlands BV, 5504 DR Veldhoven (NL)
(72) Inventor: Krikhaar, Johannes Wilhelmus Maria, NL-5504 EA Veldhoven (NL); Meester, Arnout Johannes, NL-5655 AN Eindhoven (NL); Pellens, Rudy Jan Maria, B-3900 Overpelt (BE); Van Zeijl, Hendrikus Wilhelmus, NL-2691 RS S'Gravenzande (NL)
(74) Representative: Roberts, Peter David

(57) **Abstract**

A device for locally treating a substrate is disclosed. The device includes an enclosure for forming an enclosed environment at a location on the substrate, a seal for sealing the enclosed environment between the enclosure and the substrate, a supply channel for supplying a chemical reactant to the location, and a removal channel for removing a chemical from the enclosed environment.

## Description

### FIELD

The present invention relates to a device, a lithographic apparatus and a method for manufacturing a further device.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti-parallel to this direction. It is also possible to transfer the pattern from the patterning device to the substrate by imprinting the pattern onto the substrate.

In apparatus including, but not limited to lithographic apparatus, substrates may be treated by chemicals in one way or another. For example, in a lithographic apparatus, a substrate may be treated to generate alignment markers on the substrate. The generation of markers, in conventional apparatus, may be cumbersome and expensive. In particular, problems may arise when treating a back side of a substrate, for example, when generating alignment markers on a back side of the substrate.

### SUMMARY

It is desirable to address those problems associated with treating a substrate. It is further desirable to provide an alignment marker generation apparatus and method for generating alignment markers on the back side of the substrate.

According to an aspect of the invention, there is provided a device for locally treating a substrate, the device comprising an enclosure for forming an enclosed environment at a location on the substrate, in which environment one or more processes can be performed, amongst others chemical reactions, the enclosure comprising a seal between the enclosure and the substrate, the device further comprising a supply channel for supplying a chemical reactant to the location and a removal channel to remove a chemical from the enclosed environment. In case required for the process also mechanical devices may be added in the chamber.

In an embodiment, a device for locally treating a substrate is provided. The device includes an enclosure for forming an enclosed environment at a location on the substrate, a seal for sealing the enclosed environment between the enclosure and the substrate, a supply channel for supplying a chemical reactant to the location, and a removal channel for removing a chemical from the enclosed environment.

According to an aspect of the invention, there is provided a lithographic apparatus comprising: a projection system configured to project the patterned radiation beam onto a target portion of a substrate; a substrate table constructed to hold the substrate, the substrate having a back side disposed opposite to a front side on which the target portion is located; an alignment marker generation system for forming one or more markers on a back side of the substrate, the alignment marker generation system comprising a device for locally forming an enclosed environment in which one or more chemical treatments are carried out locally to form one or more markers on the back side of the substrate.

According to an aspect of the invention, there is provided an alignment marker generation system for forming one or more markers on a substrate having a back side disposed opposite to a front side on which an exposure operation is to be carried out, the system comprising a device for locally forming an enclosed environment in which one or more chemical treatments are carried out locally to form one or more markers on the front side or the back side of the substrate.

According to an aspect of the invention, there is provided a method of generating one or more alignment markers on a back side of a substrate, the method comprising: locally chemically treating the back side of the substrate.

In one embodiment, the method includes positioning a mask to the back side of the substrate.

In a further embodiment, the mask comprises one or more markers to be generated on the substrate.

In a further embodiment, the mask is transmissive to an exposing beam and comprises a cavity having a predetermined depth in which the one or markers are disposed.

In a yet further embodiment, the method includes exposing the back side of the substrate to expose the one or more markers.

In a yet further embodiment, the method includes bringing the mask into contact with the substrate so that the one or more markers are at a predetermined distance from the substrate and exposing the one or more markers by directing an exposing beam through the cavity onto the substrate.

According to an aspect of the invention, there is provided a lithographic apparatus arranged to transfer a pattern from a patterning device onto a substrate, the lithographic apparatus comprising an enclosure for forming an enclosed environment at a location on the substrate, a seal for sealing the enclosed environment between the enclosure and the substrate, a supply channel for supplying a chemical reactant to the location, and a removal channel for removing a chemical from the enclosed environment.

According to an aspect of the invention, there is provided a device manufacturing method comprising generating one or more alignment markers on a back side of a substrate by locally chemically treating the back side of the substrate, and transferring a pattern from a patterning device onto the substrate.

According to an aspect of the invention, there is provided a device manufactured using any of the apparatus or methods described herein.

### BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 depicts a lithographic apparatus according to an embodiment of the invention;

Figure 2 depicts a device according to an embodiment of the invention for use in an alignment marker generation system according to a further embodiment of the invention;

Figure 3 depicts details to scale of a device for locally treating a substrate according to an embodiment of the invention;

Figure 4 depicts further details to scale of a device for locally treating a substrate according to an embodiment of the invention;

Figure 5 depicts details of an alignment marker generation system according to an embodiment of the invention, and

Figures 6A-F depict steps of a method of generating one or more alignment markers on a back side of a substrate according to an embodiment of the present invention.

### DETAILED DESCRIPTION

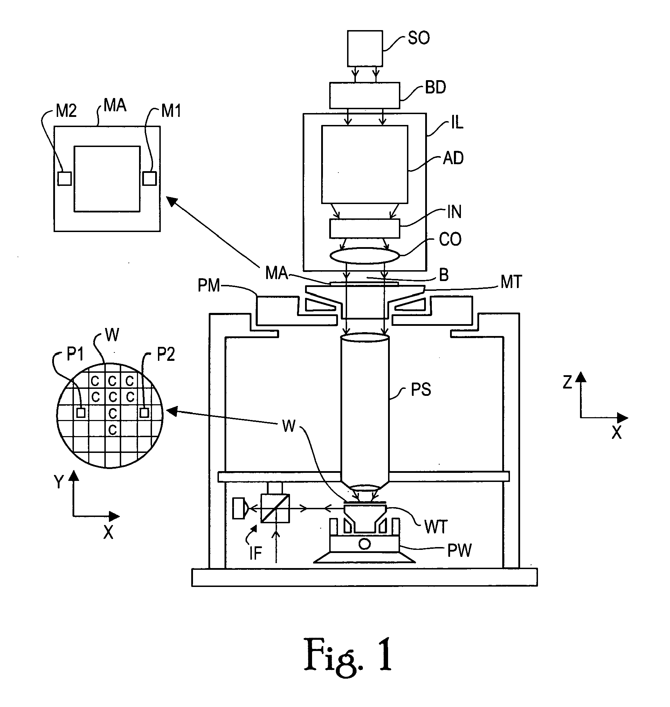

Figure 1 schematically depicts a lithographic apparatus according to one embodiment of the invention. The apparatus comprises: an illumination system (illuminator) IL configured to condition a radiation beam B (e.g. UV radiation or EUV radiation); a support structure (e.g. a mask table) MT constructed to support a patterning device (e.g. a mask) MA and connected to a first positioner PM configured to accurately position the patterning device in accordance with certain parameters; a substrate table (e.g. a wafer table) WT constructed to hold a substrate (e.g. a resist-coated wafer) W and connected to a second positioner PW configured to accurately position the substrate in accordance with certain parameters; and a projection system (e.g. a refractive projection lens system) PS configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross-section.

The radiation beam B is incident on the patterning device (e.g., mask MA), which is held on the support structure (e.g., mask table MT), and is patterned by the patterning device. Having traversed the mask MA, the radiation beam B passes through the projection system PS, which focuses the beam onto a target portion C of the substrate W. With the aid of the second positioner PW and position sensor IF (e.g. an interferometric device, linear encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:

1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

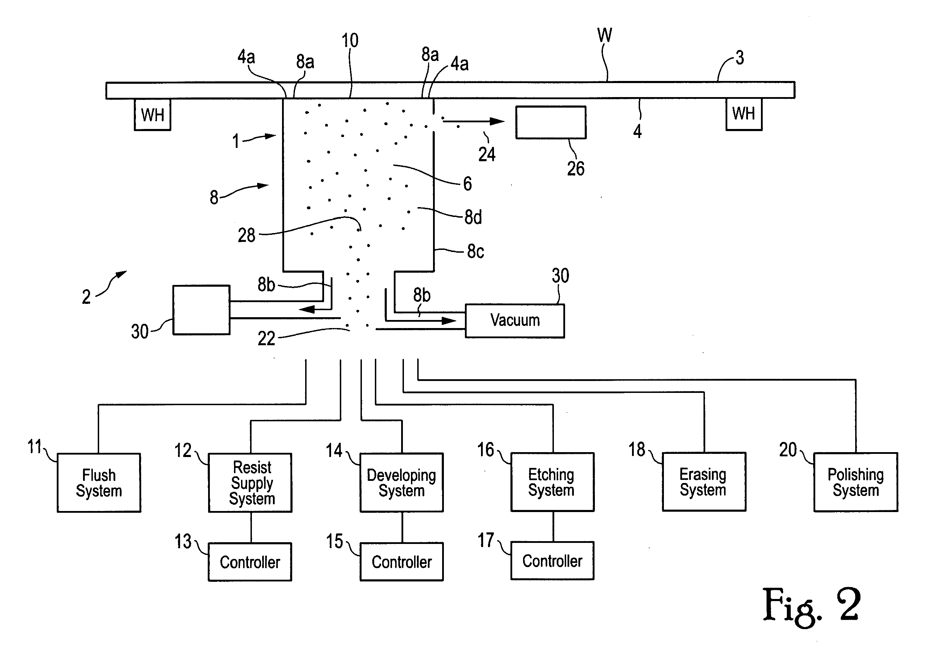

Figure 2 depicts a device according to an embodiment of the invention for use in an alignment marker generation system, which may also be referred to as an alignment marker generator, according to a further embodiment of the invention. The device 1 is for locally treating a substrate, and is described in more detail hereinbelow.

In the embodiment shown, the alignment marker generation system 2 generates alignment markers on a substrate W. The substrate has a front side 3 and a back side 4. The projection beam PB, in use, impinges on the front side 3. The back side 4 is disposed opposite to the front side 3. Typically, in use, the front side 3 is upper most and the back side 4 faces downwards. In the text the terms "front side" and "back side" refer to the orientation of the substrate in use. As mentioned in particular, with reference to the side of the substrate arranged to receive the projection beam PB, i.e. the front side 3 receives the projection beam PB and the back side 4 is the side opposite the front side 3. The embodiment shows an alignment marker generation system for use in a lithographic apparatus as described with reference to Figure 1. The invention is not however, limited in this respect and may be applied to other applications where the generation of one or more alignment markers is desired. Neither is the invention limited to the generation of markers on the back side 4 of the substrate. In an alternative embodiment, the system may be used to generate markers on a front side of a substrate. In certain embodiments, the device may comprise a mechanical device for carrying out a process in the enclosure.

Front side to back side alignment, also referred to as back side alignment provides advantages over front side only alignment. As mentioned above, however, conventionally providing backside markers is cumbersome and/or expensive to provide. According to an embodiment of the invention, the alignment marker generation system 2 is provided for forming one or more markers on a substrate W having a back side 4 disposed opposite to a front side 3 on which an exposure operation is to be carried out. The system comprises a device 1 for locally forming an enclosed environment 6 in which one or more processes, such as one or more chemical treatments, are carried out to locally form one or more markers on the back side 4 of the substrate W. The system 2 may include a device 1. The device 1 is suitable for locally treating the substrate W. The device comprises an enclosure 8 for forming the enclosed environment 6 at a location 10 on the substrate W. In the enclosed environment 6 one or mores processes, amongst others chemical and physical reactions may be carried out. The enclosure 8 comprises a seal 8a, 8b for providing a seal between the enclosure 8c, 8d and the substrate W. In one embodiment, the seal 8a, 8b is a vacuum seal. The device further comprises a supply channel 22 for supplying a chemical reactant to the location 10 and a removal channel 24 to remove a chemical from the enclosed environment 6. In this way, the substrate may be processed in a small enclosed area without the surrounding area becoming contaminated with chemicals. Further, the supply channel may be connected to a plurality of treatment systems 12-20 (described in further detail below), so that one or more chemical reactions may be carried out in the same enclosure. Thus, a plurality of processes may be carried out using a single bowl. Further, using the device according to an embodiment of the invention, local processing may be carried out. Yet further, small quantities of chemical may be used which result, for example, in low operational costs and low waste. In the enclosure, (micro-)mechanical devices may be integrated to perform a physical activity.

The enclosure 8a-8d may comprise a double structure comprising an outer structure 8c and an inner structure 8d disposed within the outer structure 8c. The outer structure 8c may be arranged to connect to a substrate surface 4 by vacuum 8b. The inner structure 8d may be arranged to be open to the surface 4, for example, the back side of the substrate W. In this way, chemical contact between chemicals in the bowl and the location 10 is achieved. The inner structure 8d may be in fluid contact with the supply channel 22 and the removal channel 24. In this way, the enclosed environment formed by the enclosure can be flushed between treatments. Further, by being able to flush the environment, a fast refresh rate of chemical in the inner structure 8d may be achieved, which results in fast processing. In one embodiment, a vacuum source 26 is provided for applying at least a partial vacuum to the removal channel to remove a chemical from the enclosed environment. In this way, products of the chemical reaction may be removed from the environment. The double structure may comprise a double bowl, a double bowl like structure or a double cylindrical structure. In one embodiment, the inner structure 8d, the supply channel 22 and the removal channel 24 are dimensioned, so that a substantially uniform process area is formed. The dimensions of the bowl and the supply and removal channels are dimensioned to achieve an environment in which a chemical reaction may take place fast. To achieve a quick reaction, the volume of the enclosed environment is relatively small. The supply channel may supply the chemical reactant to a region 28 located centrally in the enclosed environment 6. This is achieved by disposing an outlet of the supply channel in the lower center of the inner bowl 8d. Further, the vacuum seal 8a, 8b may be arranged to hold the enclosure 8c, 8d onto a surface 4a of the substrate W by a force generated by a vacuum source 30. Further, the seal may comprise a seal portion 8a defining a region lying between the inner and outer structure 8c, 8d to which a vacuum 30 is applied.

The device may be used to provide an enclosed environment in which a variety of chemical treatments, including reactions, may be carried out. The chemicals supplied and removed from the device may be at least one of a chemical reactant, a chemical product, a chemical by product, a chemical waste product and a fluid. A fluid may include a liquid, gas or mixture thereof. The device may comprise a chemically insensitive material, such as PTFE or glass.

As mentioned above, the device 1 may be comprised in the alignment marker generation system 2. The system may be a discrete unit for use in or with a lithography apparatus. The system may be a discrete unit for use in or with a lithography apparatus. Substrates which have been treated by the system 2 are transported within the apparatus.

Alternatively, the system 2 may be provided separately from a lithographic apparatus. In such an embodiment, the substrates on which the markers are generated are transported to the lithographic apparatus.

The alignment markers may be provided on the back side and/front side of the substrate. The technology herein described for providing back side markers, as shown in Figure 2, may also be applied to the front side of the substrate. Embodiments of the invention are not limited in this respect. By providing the alignment marker generation systems as a distinct apparatus, an option is provided in the substrate stepper/scanner (or in the litho cluster) where it is possible to create alignment markers without suffering exposure time loss from the projection system PS, which includes expensive components. Thus, users may make use of the possibility to feed blank substrates to the scanner and get the "zero" layers processed, including the generation of markers, without a throughput impact on the stepper/scanner (or litho cluster). The alignment marker generation system according to an embodiment of the invention, has a limited volume combined with a reasonable cost of goods. Its functionality may be used in the substrate stepper/scanner. It will be realized that the build up of the components in the option for generating front side markers is different from the configuration in the back side marker tool, as shown for example, in Figure 2.

The alignment marker generation system 2 may comprise a substrate holder WH for holding the substrate W so that, in use, the front side 3 is upper most and the back side 4 is underneath.

The alignment marker generation system 2 may comprise one or more sub-systems for carrying out steps in the production of the alignment marker. Some of the sub-systems, such as a resist supply system 12 and a developing system 14 include carrying out a chemical reaction using, for example, the device. Other sub-systems, such as a mask positioning system PS and an exposing system, do not involve carrying out a chemical reaction. In Figure 2 only those sub-systems which involve the carrying out of a process, such as a chemical treatment are shown.

In particular, the alignment marker generation system may comprise a resist supply system 12 for supplying resist to the supply channel 22 in the device, the resist supply system 12 comprising a control unit 13 for controlling the supply of resist so that the resist is sprayed as a coating locally on the back side 4 of the substrate W. In an alternative embodiment, the resist is applied by a spray process, in which resist is sprayed directly onto the substrate. In such an alternative embodiment, the resist supply system and the control unit are not used in conjunction with a device. Rather, the resist is sprayed directly onto the substrate W. A mask positioning system PS for positioning a mask to the back side of the substrate may be provided. The mask may comprise one or more markers to be reproduced on the substrate. The mask positioning system PS may be arranged to position the mask using a contact or proximity technique. A further sub-system may include an exposing system for exposing the one or more markers on the mask. The alignment marker generation system may further comprise a developing system 14, 15 for locally developing the markers on the back side 4 of the substrate W. The developing system 14, 15 may comprise a developer supply system 14 for supplying developer to the supply channel 22 in the device 1. The developer supply system may further comprise a control unit 15 for controlling the supply of developer so that the developer is sprayed locally on to the one or more markers on the back side 4 of the substrate W. The alignment marker generation system may comprise an etching system 16, 17 for locally etching the one or more markers on the back side 4 of the substrate W. The etching system 16 may comprise a wet etching system carried out in one or more devices, a plasma etching system or an etch supply system 16 for supplying a chemical etcher to the supply channel 22 in the device 1. The etch supply system 16, 17 comprising a control unit 17 for controlling the supply of the chemical etcher so that the etcher is sprayed locally on to the one or more markers on the back side 4 of the substrate W. The alignment marker generation system may further comprise an erasing system 18 for erasing the resist. The erasing system 18 may comprise a device comprising an enclosure, as described above. The device included in the erasing system 18 may be larger than devices used in other systems. In this way, the substrate W may be cleaned. It may further comprise a polishing system 20 for locally polishing the back side 4 of the substrate W prior to providing a coating of resist on the substrate W. In an alternative embodiment, the polishing is not carried out in conjunction with the device 1, but may be carried out without the use of the device.

In those sub-systems in which a chemical treatment is involved, for example, the resist supply system, developing system, etching system, erasing system, and polishing system, the reactants for the treatment are supplied to the device, as described above with reference to the device. In particular, they are supplied to the inner structure 8d, where they react in the enclosed environment 6. The seal 8a, 8b prevents reactants or products from leaving the enclosed environment and contaminating the lithographic apparatus or outside environment. Further, the vacuum applied to the removal channel 24 ensures that excess reactants, by products, etc. are removed from the enclosed environment once the reaction is complete. The sub-systems are arranged so that each sub-system may supply its reactants to the supply channel 22 independently.

In order to clean the enclosed environment in between chemical treatments, the alignment marker generation system may also comprise a flushing liquid supply system 11 for supplying a flushing liquid to the enclosed environment 6 to flush the environment 6. In this way contamination between treatments is reduced.

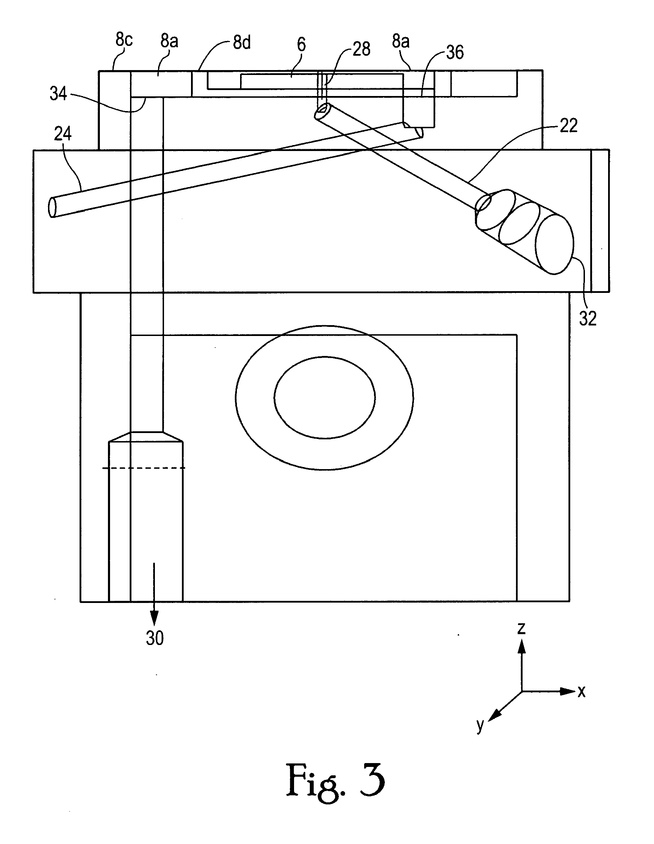

Figure 3 depicts details of a device for locally treating a substrate according to an embodiment of the invention. In particular, Figure 3 shows a cross section through a device according to an embodiment of the invention in the x-z plane. The supply channel 22 supplies a chemical reactant to a region 28 located centrally in the enclosure 6. An attachment 32 may be provided to attach the supply channel 22 to the sub-systems 11, 12, 13, 14, 15, 16, 17, 18, 20, respectively. The enclosure comprises an inner structure 8d and an outer structure 8c. In the embodiment shown, the structures have substantially concentric walls. The inner structure 8d being disposed within the outer structure 8c. The seal 8a is formed by providing an outlet 34 in the region between the inner and the outer structures 8c, 8d. The outlet is provided in the device and extends through the device to the vacuum source 30, to which it is connected. In order to remove chemicals from the enclosure 6, an outlet 36 is provided in the structure of the inner structure 8d. The outlet 36 is comprised in the removal channel 24. The removal channel is connected to the vacuum source 26 (not shown in Figure 3).

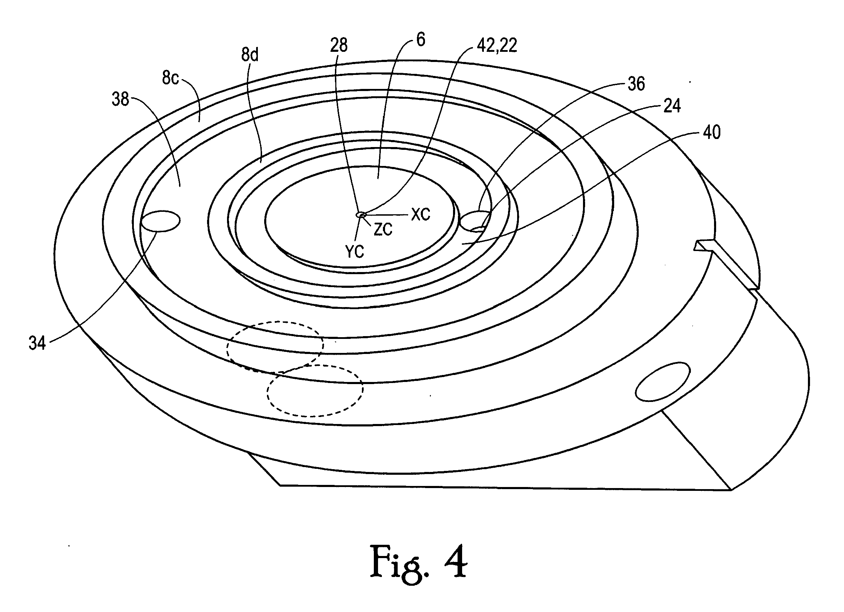

Figure 4 depicts further details of a device for locally treating a substrate according to an embodiment of the invention. In particular, Figure 4 depicts a top view of the device shown in Figure 3. It is seen that the outlet 34 is disposed in the floor 38 of the outer structure 8d in order so that a vacuum can be applied to the region between the inner and outer structure 8d, 8c, to provide a seal 8a. Further outlet 36 is provided in the floor 40 of the inner structure 8c, which is connected to vacuum source 26, so that excess reactants, by products and excess products, as well as the flushing gas may be removed from the enclosed environment 6. A relatively small opening 42 which connects to the supply channel 22 is also provided in the inner structure 8d. The small opening allows the reactants to enter the enclosed environment 6.

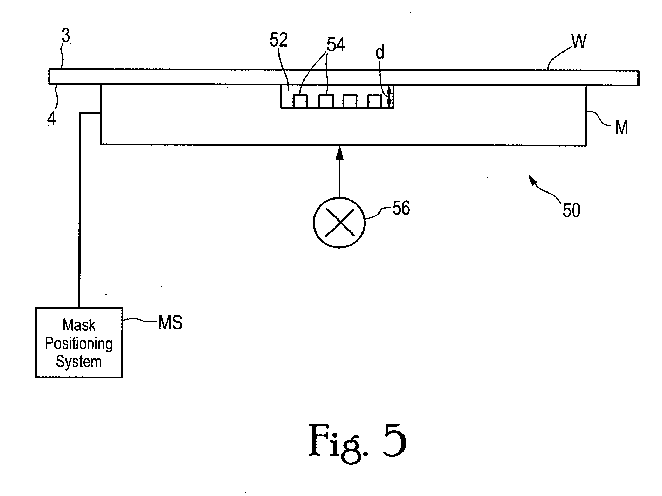

Figure 5 depicts details of an alignment marker generation system according to an embodiment of the invention. In particular, Figure 5 shows an exposure system for use in the alignment marker generation system 2. In the embodiment shown, the exposure system 50 is arranged to expose a marker to be generated on the back side 4 of the substrate W. The exposure system 50 is arranged to carry out the exposure with a combination of proximity and contact exposure. This is possible, since the exposure takes place locally and thus, the total image to be exposed is relatively small. In accordance with an embodiment of the invention, the mask M may comprise a cavity 52 having a predetermined depth d in which one or more markers 54 are disposed. The mask M may be disposed on the substrate W so that the one or more markers 54 are disposed at a predetermined distance from the substrate W. This is achieved by virtue of the depth of the cavity being predetermined. In one embodiment, the pattern of two alignment markers is placed on a mask, which may be formed from a piece of glass. The alignment markers to be exposed are not placed on the surface of the glass, but inside the cavity 52 which is etched into the glass. In one embodiment, the method may include bringing the mask into contact with the substrate so that the one or more markers are at a predetermined distance from the substrate and exposing the one or more markers by directing an exposing beam through the cavity onto the substrate. The exposure may comprise pressing the glass to the resist on the substrate followed by the exposure of the markers by a radiation source, such as an exposure lamp 56. By providing a cavity with a predetermined depth, the imaging is controlled. In particular, by providing a relatively small depth, imaging is optimized. Whereas a conventional contact exposure may have the disadvantage of damaging the image during the different exposures, in accordance with an embodiment of the invention, the advantages of contact printing are achieved, without the disadvantage of risking damage to the pattern. Thus, the proximity mask in accordance with an embodiment of the invention has a relatively long lifetime. For a proximity exposure, the reproduction of the exposure is good because the pattern is at a predetermined distance from the resist, due to the depth d of the cavity being predetermined. Figure 5 further shows a mask positioning system MS for positioning the mask M with respect to the substrate W.

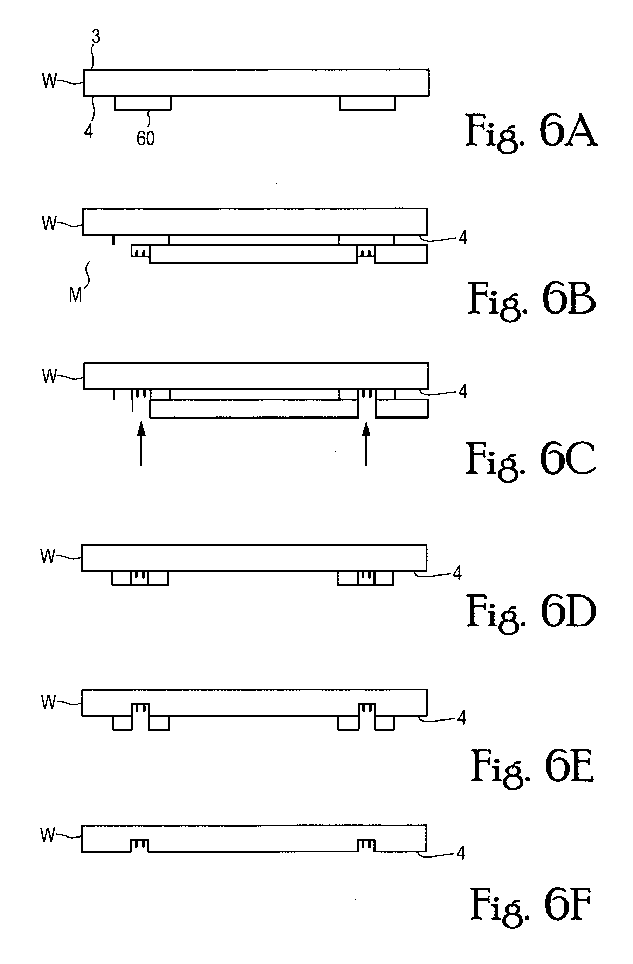

Figures 6A-F depict steps of a method of generating one or more alignment markers on a back side of a substrate according to an embodiment of the present invention. Conventionally, providing substrates with back side markers is cumbersome and expensive. According to embodiments of the invention, back side markers may be generated relatively cheaply and readily. The method may include locally chemically treating the back side of the substrate. Further, forming an enclosed environment at a location on the back side of the substrate, in which environment a chemical reaction occurs. Forming the enclosed environment by applying an enclosure including a vacuum seal locally to the substrate for providing a seal between the enclosure and the substrate. The method may further include supplying a chemical reactant to the enclosed environment and removing a chemical from the enclosed environment. In the embodiment shown in Figure 6, the method includes supporting the substrate with a front side uppermost and the back side underneath.

The process for generating the back side markers may comprise, with reference to Figure 6A, spraying a resist 60 locally on the back side 4 of a substrate W wherein the substrate is disposed with a front side 3 upper facing. With reference to Figure 6B, positioning a mask to the back side of the substrate. The mask may comprises one or more markers to be generated on the substrate. Further, the mask may be transmissive to an exposing beam and comprises a cavity having a predetermined depth in which the one or markers are disposed. With reference to Figure 6C, the method may include exposing the back side 4 of the substrate W to expose the one or more markers. With reference to Figure 6D, the method may include locally developing the markers on the back side 4 of the substrate W. The developing may include locally spraying a developer on the back side 4 of the substrate W. With reference to Figure 6E, the method may include locally etching the markers by applying a chemical etcher to the back side of the substrate. The etching may include wet etching using one or more devices described with reference to Figure 2, or using a spray etch approach. With reference to Figure 6F, the method may include erasing the resist. The erasing my be by a standard cleaning or resist stripping technology. This step may also be carried out on a different apparatus. Further, plasma etching may be carried out as an alternative to the etching step. Furthermore, if a single-side polished (SSP) substrates are used, it may be desirable to include a local polishing step before spraying the resist. Thus, the method may include locally polishing the substrate before spraying the resist onto the substrate W.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. A device for locally treating a substrate, the device comprising:
an enclosure for forming an enclosed environment at a location on the substrate;
a seal for sealing the enclosed environment between the enclosure and the substrate;
a supply channel for supplying a chemical reactant to the location; and
a removal channel for removing a chemical from the enclosed environment.

2. A device according to claim 1, wherein said enclosed environment is configured for one or more processes to occur therein.

3. A device according to claim 2, wherein said one or more processes includes one or more chemical reactions.

4. A device according to any preceding claim, wherein the enclosure comprises the seal.

5. A device comprising to claim 4, wherein the enclosure comprises a double structure comprising an outer structure and an inner structure disposed within the outer structure, the outer structure being arranged to be sealed to a substrate surface by a vacuum and the inner structure being arranged to be open to the substrate surface.

6. A device according to claim 5, wherein the inner structure is in fluid contact with the supply channel and the removal channel.

7. A device according to claim 6, wherein the inner structure, the supply channel and the removal channel are dimensioned so that a substantially uniform process area is formed.

8. A device according to any of claims 5 to 7, further comprising a vacuum source for applying at least a partial vacuum to the removal channel to remove the chemical from the enclosed environment.

9. A device according to any of claims 5 to 8, wherein the double structure comprises a double bowl, a double bowl like structure, or a double cylindrical structure.

10. A device according to any of claims 5 to 9, wherein the seal comprises a seal portion defining a region between the inner structure and the outer structure to which a vacuum is applied.

11. A device according to any preceding claim, wherein the supply channel supplies the chemical reactant to a region located centrally in the enclosed environment.

12. A device according to any preceding claim, wherein the seal is arranged to hold the enclosure onto a surface of the substrate by a force generated by a vacuum source.

13. A device according to any preceding claim, wherein the chemical is at least one of a chemical reactant, a chemical product, a chemical by-product, a chemical waste product, and a fluid.

14. A device according to any preceding claim, wherein the device comprises a chemically insensitive material.

15. A device according to claim 14, wherein the chemically insensitive material is PTFE or glass.

16. A device according to any preceding claim, further comprising a mechanical device for carrying out a process in the enclosure.

17. A lithographic apparatus comprising:
a projection system configured to project the patterned radiation beam onto a target portion of a substrate;
a substrate table constructed to hold the substrate, the substrate having a back side disposed opposite to a front side on which the target portion is located; and
an alignment marker generator that forms one or more markers on the back side of the substrate, the alignment marker generation system comprising an enclosure device for locally forming an enclosed environment in which one or more chemical treatments are carried out locally to form the one or more markers on the back side of the substrate.

18. An alignment marker generation system for forming one or more markers on a substrate having a back side disposed opposite to a front side on which an exposure operation is to be carried out, the system comprising a device for locally forming an enclosed environment in which one or more chemical treatments are carried out locally to form said one or more markers on the front side or the back side of the substrate.

19. An alignment marker generation system according to claim 18, further comprising: a substrate holder for holding the substrate so that, in use, the front side is upper most and the back side is underneath and so that the one or more chemical treatments are carried out locally on the back side.

20. An alignment marker generation system according to claim 18 or claim 19, wherein the system is a discrete unit for use in or with a lithography apparatus.

21. A method of generating one or more alignment markers on a back side of a substrate, the method comprising: locally chemically treating the back side of the substrate.

22. A method according to claim 21, further comprising forming an enclosed environment at a location on the back side of the substrate, in which environment a chemical reaction occurs.

23. A method according to claim 22, further comprising forming the enclosed environment by applying an enclosure including a vacuum seal locally to the substrate for providing a seal between the enclosure and the substrate.

24. A method according to any of claims 21 to 23, further comprising supplying a chemical reactant to the enclosed environment and removing a chemical from the enclosed environment.

25. A method according to any of claims 21 to 24, further comprising supporting the substrate with a front side uppermost and the back side underneath.

26. A method according to claim 21, further comprising spraying resist locally on the back side of the substrate.

27. A method according to claim 26, further comprising locally developing the markers on the back side of the substrate.

28. A method according to claim 27, wherein said developing includes locally disposing a developer on the back side of the substrate.

29. A method according to claim 21, further comprising locally etching the markers by applying a chemical etcher to the back side of the substrate.

30. A method according to claim 26, further comprising erasing the resist.

31. A method according to claim 26, further comprising locally polishing the substrate before spraying the resist onto the substrate.

32. A lithographic apparatus arranged to transfer a pattern from a patterning device onto a substrate, the lithographic apparatus comprising:
an enclosure for forming an enclosed environment at a location on the substrate;
a seal for sealing the enclosed environment between the enclosure and the substrate;
a supply channel for supplying a chemical reactant to the location; and
a removal channel for removing a chemical from the enclosed environment.

33. A lithographic apparatus arranged to transfer a pattern from a patterning device onto a substrate, the lithographic apparatus comprising:
an alignment marker generation system for forming one or more markers on the substrate having a back side disposed opposite to a front side on which an exposure operation is to be carried out, the system comprising a device for locally forming an enclosed environment in which one or more chemical treatments are carried out locally to form said one or more markers on the front side or the back side of the substrate.

34. A device manufacturing method comprising:
generating one or more alignment markers on a back side of a substrate by locally chemically treating the back side of the substrate; and
transferring a pattern from a patterning device onto a substrate.

35. A device manufactured according to claim 34.
